Europäisches Patentamt

European Patent Office

Office européen des brevets

(19)

(11) **EP 1 274 173 A2**

(12) # EUROPEAN PATENT APPLICATION

(43) Date of publication:
**08.01.2003 Bulletin 2003/02**

(51) Int Cl.$^7$: **H03M 13/17**

(21) Application number: **02254412.6**

(22) Date of filing: **24.06.2002**

(84) Designated Contracting States:
**AT BE CH CY DE DK ES FI FR GB GR IE IT LI LU MC NL PT SE TR**
Designated Extension States:
**AL LT LV MK RO SI**

(30) Priority: **02.07.2001 GB 0116157**

(71) Applicant: **MATSUSHITA ELECTRIC INDUSTRIAL CO., LTD.**
**Kadoma-shi, Osaka 571-8501 (JP)**

(72) Inventor: **Kuang, Wen Tao,**
**c/o Matsushita Communication**
**Thatcham, Berkshire RG19 4ZD (GB)**

(74) Representative: **Dawson, Elizabeth Ann et al**
**A.A. Thornton & Co.**
**235 High Holborn**
**London WC1V 7LE (GB)**

(54) **Error trapping and correction for cyclic codewords**

(57) A method of error trapping and correction for cyclic codewords using word-wise calculation, reversed cyclic shift or error trapping, word-wise error trapping and word-wise error correction, in order to reduce the number of required instruction cycles in a digital signal processor for error correction.

Fig.9

**Description**

1. Introduction

The present invention relates to a method of error trapping for use in error correction in cyclic codewords. The invention has been especially developed for the decoding of a shortened Fire code that is specified in GMS 05.02 Digital Cellular Communications System (Phase 2+) Channel Coding, and more particularly for the channels GPRS/CS-1, SACCH, FACCH, BCCH, PCH, AGCH, NCH, CBCH, CTSPCH, CTSAGCH, SDCCH and E-FACCH/F. However, the invention is applicable to the decoding of Fire codes for other applications.

The specification of the shortened Fire code mentioned above is given in the following table:

TABLE 1.1

| Specification of the Fire code | |
|---|---|
| Polynomial | $g(D)=(D^{23}+1)*(D^{17}+D^3+1)$ |
| Length of the shortened code ($n$) | 224 |
| Length of message ($k$) | 184 |
| No. of parity bits ($n$-$k$) | 40 |
| Burst-error-correcting capability $l$ | 12 |
| Length of the full code word ($n'$) | 3014656 |

2. Overview of Fire Codes

This section only provides brief information on the conventional encoding and decoding methods used for general Fire codes, for more detailed description on this topic, please refer to Section 9.3 of Lin, S, and Daniel J Costello, Jr. "Error Control Coding", Prentice Hall, Inc., Englewood Cliffs, N.J., 1983.

Fire codes are the cyclic codes constructed systematically for signal-burst-error correction. The general expression of the generator polynomial for a Fire code is given as:

$$g(D) = (D^{2l-1}+1)p(x)$$

Where, l is the burst-error-correcting capability, the maximum length of a correctable error burst, and **p**(x) is a primitive polynomial. Given the polynomial, the full length of the code word, $n$ is determined by the period ρ of **p**(x) and $l$:

$$n = LCM(2l-1, ρ)$$

(LCM - least common multiplier)

In this particular case, where the polynomial is given as:

$$g(D)=(D^{23}+1)(D^{17}+D^3+1)$$

The full length of the Fire code is determined as $23 \times 2^{17} = 3014656$.

2.1. Encoding of the Fire Code

The encoding method of a Fire code is the same as the one used for CRC (cyclic redundancy check) codes.

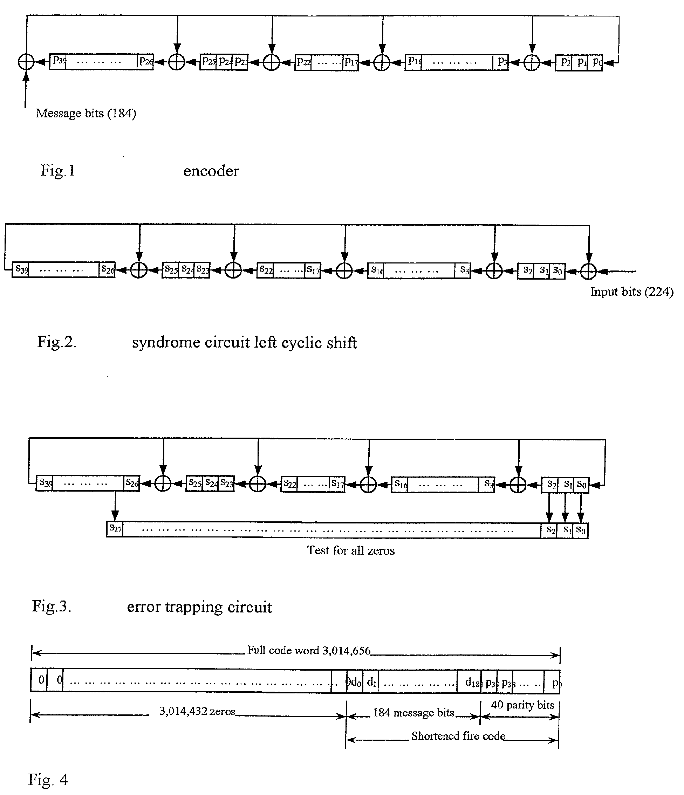

A suitable encoder is illustrated in Figure 1 for a (224,184) Fire code. After all 184 message bits have been shifted into the above encoder, the contents of the shift register, which are also known as the parity check bits are appended to the message bits systematically (as follows) to form a Fire code.

$$d_0D^{223} + d_1D^{222} + ..... + d_{183}D^{40} + p_{39}D^{39} + p_{38}D^{38} + ..... + p_1D + p_0$$

where, $d_i$ represents the input message bits and $p_i$ represents the parity check bits.

2.2. Decoding and Error Correction of Fire code

The decoding of a Fire code involves the following two steps:

1.Syndrome calculation
2.Error trapping and correction

◆Syndrome calculation

By dividing the received sequence $\mathbf{r}(X)$ by the generating polynomial $\mathbf{g}(X)$, the syndrome sequence $\mathbf{s}(X)$ is determined as the remainder. This division can be performed with the following circuit.
After all 224 received bits have been shifted into the above syndrome circuit, the syndrome is obtained as the contents of the register. A zero syndrome is obtained if and only if there is no error involved in the received data or the error is divisible by $\mathbf{g}(X)$, i.e. the erroneously received code happens also to be another valid code.

◆Error trapping and correction

After a non-zero syndrome is obtained, the decoder starts to search for a correctable error pattern. This process is normally referred to as error trapping, which can be achieved by turning off the input and continuously cyclically shifting the decoder left towards the most significant bit, until the error pattern is trapped in the most significant 12 bits. This is indicated by the zeros filling bits 0-27 of the syndrome register. This process is illustrated by the diagram of figure 3.
After determining the error pattern, its location in the received data is obtained as the number of cyclic shifts performed. Then, the error correction is performed by XOR'ing the error pattern to a certain location of the received data.

**Summary of the invention**

Conventionally, during every iteration of the syndrome calculation, the most significant bit of the shift regulator is shifted out and XOR'ed with the input bit to obtain the fed back bit. This bit determines whether or not the content of the register should be XOR'ed with the coefficients of the generator polynominal represented as vector $\mathbf{g}$. To speed up this process, it has been proposed to shift the contents of the shift register byte by byte instead of bit by bit. This necessitates calculating a "fed back byte" instead of a fed back bit. The fed back byte may be determined from a look up table storing a fed back word corresponding to every possible byte shifted out of the shift register. Alternatively, a non-table driven technique has been proposed in which the fed back byte is calculated in situ. This is discussed in an article by Jack Crenshaw in Embedded Systems Programming, January 1992, pages 34-40.
As will become apparent from the following description, this "multiple bit shifting" has numerous advantages in terms of speed of operation and efficient use of hardware.
The present invention extends this multiple bit shifting technique to the processes of error trapping, error detection and error correction which follow the computation of a non-zero syndrome. The invention is described in appended claim 1 and preferred features of the invention are described in the dependent claims.
It is particularly advantageous for the process to be carried out in a byte wise manner, i.e. 8 bits at a time, although in theory any number of bits can be shifted at once, subject to the limitations ofthe burst-error correcting capacity. With the advent of 16 bit processors, it is even more advantageous to carry out the process in a word-wise manner, i.e. 16 bits at a time. Word-wise shifting is used in the preferred embodiment to be described below.
In the preferred method of the invention, for greater speed, the multiple bit wise error trapping, detection and correction are carried out in conjunction with reversed cyclic shifting as described above. Thus, the direction of shifting for error correction is opposite to the direction of shifting used for syndrome calculation.
An embodiment of the invention will now be described by way of example only and with reference to the accompanying drawings. In the drawings:

Figure 1 is a schematic diagram in conventional form illustrating an encoder for a (224,184) Fire code;

Figure 2 is a schematic diagram of a syndrome circuit for a (224,184) Fire code;

Figure 3 is a schematic diagram of an error trapping circuit for a (224,184) Fire code;

Figure 4 illustrates the structure of a shortened Fire code;

Figure 5 illustrates error trapping with reversed cyclic shift;

Figure 6 shows the result of 15 over-shifts of the error pattern after a word-wise cyclic shift;

Figure 7 illustrates the error trapping circuit after the direction is changed;

Figure 8 illustrates word-wise error correction;

Figure 9 is a flow chart showing the processes of error trapping, detection and correction.

3.Decoding the Shortened Fire Code

A modified Fire decoder according to the present invention is presented in this section. It is especially designed to achieve the maximum efficiency for shortened Fire code decoding.
First the concept of the shortened Fire code is explained.

3.1. Shortened Fire Code

The shortened Fire code (224,184) specified in the GSM standard is only a subset of the full Fire code determined by the given polynomial $\mathbf{g}(X)$. The full code word of these shortened Fire codes has the structure shown in Fig 4.
Although, the 3,014,432 zeros in front of the message bits are not transmitted, they are implicitly shifted into the encoder/decoder, thus causing no effect at all, during the encoding and syndrome calculation. However, while 'error trapping' with the conventional method introduced earlier, these zeros are taken into account. The error searching starts from the very beginning of the full code word, where the zeros are located. This means that it will take at least 3,014,432 shifts before a correctable error burst can be possibly identified. It is obviously unrealistic for any system to perform such a huge amount of operations in real time. Therefore, the 'reverse cyclic shift' technique has been developed and is briefly described in the following section. This technique is capable of skipping the 3,014,432 implicit shifts and trapping the error pattern within 224 cyclic shifts.

3.2. Error Trapping with Reversed Cyclic Shift

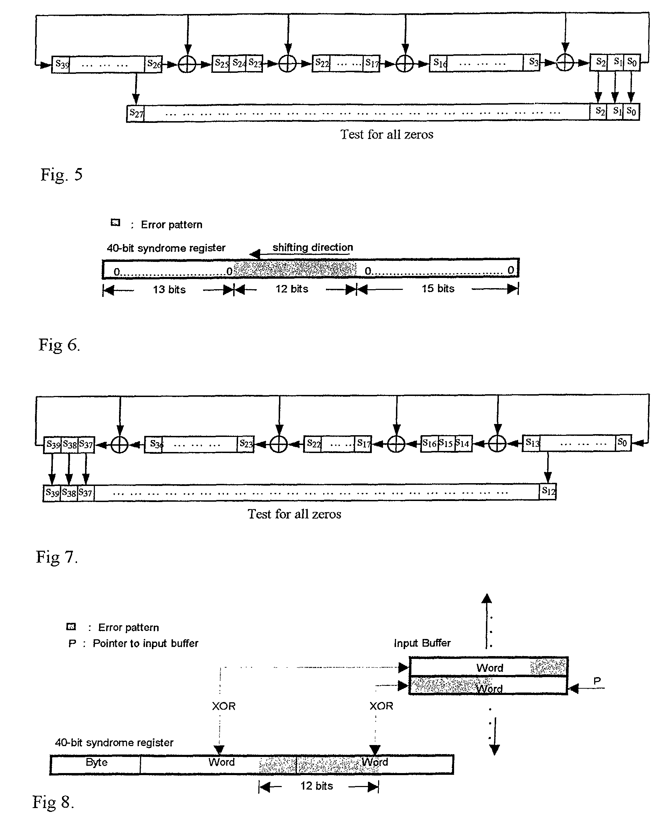

One possible way of skipping the 3,014,432 shifts is to search the error pattern backward from the tail of the code word. In that case, it will take no more than 224 shifts to search the whole received sequence including the 40 parity bits. To achieve this, the reversed cyclic shift is proposed for error trapping. The idea of this technique is very simple: instead of shifting the syndrome cyclically left, this technique performs a right cyclic shift. As a result, the error trapping procedure starts from the tail of the code word. This technique is illustrated in Fig 5.
Comparing the above error trapping decoder of Fig. 5 with the one shown in Fig. 3, the only difference observed is the reversed shifting direction. Just by this small difference, the processing speed of the 'error trapping' for this shortened fire code has been improved by thousands of times.
The theoretical proof of this technique is given as follows:
The theorem that validates the error trapping technique is, 'Let s(X) be the syndrome of a received polynomial $r(X) = r_0 + r_1 X + ... + r_{n-1} X^{n-1}$ *, then the remainder $s^{(1)}(X)$ resulting from dividing Xs(X) by the generator polynomial g(X) is the syndrome of $r^{(1)}(X)$'. The proof of this theorem can be found in the Section 4.4 of the aforementioned Lin & Costello textbook.
Because s(X) is also the syndrome of itself, the above theorem describes the left cyclically shifted syndrome, $s^{(1)}(X)$ as the syndrome of Xs(X). However, in general, s(X) is actually the syndrome of $X^{vn}s(X)$, where n is the code word length and v is a integer, 0,1,2,3,......... Subsequently, $s^{(1)}(X)$ is the syndrome of $X^{vn+1}s(X)$.
Now considering the polynomial $X^{vn-1}s(X)$, which can be rewritten as $X^{(v-1)n+n-1} s(X)$. Its syndrome is $s^{(n-1)}(X)$ representing the result of n-1 left cyclic shift of s(X). Assuming $s^{(-1)}(X)$ is the result of a right cyclic shift of the s(X), proof:

$$s^{(-1)}X = s^{(n-1)}(X)$$

Proof:

Assuming:

$$s^{(n-1)}(X)=s_{u-1}X^{u-1} + s_{u-2}X^{u-2} + ...................+ s_1X^1 + s_0$$

where, u = n - k for a (n,k) cyclic code.
The generator polynomial is given as:

$$g(X) = g_uX^u + g_{u-1}X^{u-1} + g_{u-2}X^{u-2} + .................... + g_1X + g_0$$

$$= g_uX^u + g'(X) + g_0$$

Because $g_u$ and $g_0$ are always 1, the above equation is rewritten as

$$g(X) = X^u + g'(X) + 1 \qquad (1)$$

Performing a left cyclic shift on $s^{(n-1)}(X)$, determines the syndrome $s^{(n)}(X)$, which is the remainder of dividing $X^{vn+n}s(X)$ by $g(X)$:

$$s^{(n)}(X)= s(X) = s_{u-1}\times g'(X) + Xs^{(n-1)}(X) + s_{u-1}(X^u + 1)$$

Where, $s_{u-1}$ becomes the lowest order coefficient of the polynomial s(X).
A right cyclic shift of s(X) is presented with the following equation:

$$\mathbf{s}^{(-1)}X = X^{-1}[s_{u-1}\times \mathbf{g'}(X)+\mathbf{s}(X)]+s_{u-1}(X^{u-1} + X^{-1}) \qquad (2)$$

*Note*: In the received sequence **r**(X), The coefficient of the higher order, in this case the $r_{n-1}$ is the first one to be shifted into the syndrome circuit
Substituting equation (2) into the above polynomial, yields:

$$\mathbf{s}^{(-1)}X = X^{-1}[s_{u-1}\times \mathbf{g'}(X)+s_{u-1}\times \mathbf{g'}(X)+X\mathbf{s}^{(n-1)}(X)+s_{u-1}(X^u +1)]+s_{u-1}(X^{u-1} + X^{-1})$$

$$= X^{-1}[X\mathbf{s}^{(n-1)}(X)+s_{u-1}(X^u +1)]+s_{u-1}(X^{u-1} + X^{-1})$$

$$= \mathbf{s}^{(n-1)}(X)+ X^{-1}s_{u-1}(X^u +1)+ X^{-1}s_{u-1}(X^u +1)$$

$$= \mathbf{s}^{(n-1)}(X)$$

This completes the proof.
According to the theorem introduced earlier, the remainder $s^{(n-1)}(X)$ resulting from dividing $X^{n-1}s(X)$ by $g(X)$ is the syndrome of $r^{(n-1)}(X)$. Since $s^{(-1)}(X) = s^{(n-1)}(X)$, $s^{(-1)}(X)$ is also the syndrome of $r^{(n-1)}(X)$, this leads the following conclusion:
Let s(X) be the syndrome of r(X). Cyclically shifting s(X) in a reversed direction (right) for i times, results the polynomial $s^{(-i)}(X)$, which is the remainder of dividing $X^{n-i}s(X)$ by $g(X)$ and also the syndrome of $r^{(n-i)}(X)$.
This conclusion validates. the use of reversed cyclic shift for error trapping.

4.Implementing Fire Decoder.

This section describes the implementation of the previously introduced Fire decoder. By employing the 'word-wise cyclic shifting' technique, the processing speed of the Fire code decoding is significantly improved purely by software.

4.1 Syndrome Calculation with Word-wise Cyclic Shift

In order to understand how error trapping can be carried out in a word-wise manner it is first necessary to understand word wise syndrome calculation. As noted above, in order to speed up the syndrome calculation process, instead of calculating the feedback bit bit by bit, 16 fedback bits are calculated at once for every word-wise cyclic shift. These 16 bits will be referred to as the fedback word. Thereafter, according to the '1's in the fedback word, the correspondingly shifted **g** are XOR'ed to the contents of the register. The result of this process is equivalent to 16 cyclic shifts. This technique is named as 'word-wise cyclic shift', which involves following 3 steps:

1.Determine the fedback word.
2.Shift the register left by a word.
3.According to the fedback word, XOR the correspondingly shifted **g**($X$) together with the contents of the register.

The detailed operations involved in each of the above steps are demonstrated with the following example.
Example: Suppose the 40-bit syndrome register contains the value '0110101111010111000010001101011011101101', and the next message word is assumed as '1101001000001000'. Now, the next iteration of the word-wise cyclic shift is started:

1. Determine the fedback word:

♦ XOR the next message word with the most significant 16 bits, the top word from the syndrome register.

$$
\begin{array}{r}
0\ 1\ 1\ 0\ 1\ 0\ 1\ 1\ 1\ 1\ 0\ 1\ 0\ 1\ 1\ 1 \\
+\quad 1\ 1\ 0\ 1\ 0\ 0\ 1\ 0\ 0\ 0\ 0\ 0\ 1\ 0\ 0\ 0 \\
\hline
1\ 0\ 1\ 1\ 1\ 0\ 0\ 1\ 1\ 1\ 0\ 1\ 1\ 1\ 1\ 1
\end{array}
$$

♦ Calculate the fedback word, **f**:
modify the fed back word by XOR'ing its last two bits and its first two bits to account for the tap at bit 26 of the shift register (fig. 2).

$$
\begin{array}{l}
1\ 0\ 1\ 1\ 1\ 0\ 0\ 1\ 1\ 1\ 0\ 1\ 1\ 1\ 1\ 1 \\
+\qquad\qquad\qquad 1\ 0\ 1\ 1\ 1\ 0\ 0\ 1\ 1\ 1\ 0\ 1\ 1\ 1\ 1\ 1 \\
\hline
\text{Fedback word:}\qquad 1\ 0\ 1\ 1\ 1\ 0\ 0\ 1\ 1\ 1\ 0\ 1\ 1\ 1\ 0\ 1
\end{array}
$$

2. Shift the register left by a word:

♦ The content of the register is now :

$$00001000110101101110110100000000000000000$$

3. Shift **g** according to the fedback word and XOR them together to obtain the modification word, **m**. By XOR the modification word with the contents of the register the result of 16 cyclic shifts is obtained.

Note: The vertical column is the fedback word

```
1  :       01000001000000000000001001
0  :       00100000100000000000001001
1  ::       10010000010000000000001001
1  X       01001000001000000000001001
1  X       00100100000100000000001001
0  X       00010010000010000000001001
0  X       00001001000001000000001001
1  X       00000100100000100000001001
1  X       00000010010000010000001001
1  X       00000001001000001000001001
0  X       00000000100100000100001001
1  X       00000000010010000010001001
1  X       00000000001001000001001001
1  X       00000000000100100000100001001
0  X       00000000000010010000010000001001
+  1  X    00000000000001001000001000000000001001
       -----------------------------------------------------------------------------
```

Modification word:    1011101011101001001111110111011100110101

```
                   00001000110101101110110100000000000000000  register content
+                  1011101011101001001111110111011100110101  modification word
       -----------------------------------------------------------------------------
```

Result:   1011001000111111110100100111011100110101

As shown above, the modification word, m is actually obtained, by modulo2 convolving the fedback word **c** with the generator coefficient vector **g**.

$$m = f*g$$

Rearrange the above equation, yields:

$$m = g*f$$

Which implies that /the modification word, **m** can also be determined with the following calculation:

```
                                    0000100011010110111011010000000000000000
                          0  X    1
                          0  X    01
                          0  X    101
                          0  X    1101
                          0  X    11101
                          0  X    011101
                          0  X    1011101
                          0  X    11011101
                          0  X    111011101
                          0  X    0111011101
                          0  X    00111011101
                          0  X    100111011101
                          0  X    1100111011101
                          1  X    11100111011101
                          0  X    011100111011101
                          0  X    1011100111011101
                          1  X     1011100111011101
                          0  X      1011100111011101
                          0  X       1011100111011101
                          0  X        1011100111011101
                          0  X         1011100111011101
                          0  X          1011100111011101
                          1  X           1011100111011101
                          0  X            1011100111011101
                          0  X             1011100111011101
                          0  X              1011100111011101
                          0  X               1011100111011101
                          0  X                1011100111011101
                          0  X                 1011100111011101
                          0  X                  1011100111011101
                          0  X                   1011100111011101
                          0  X                    1011100111011101
                          0  X                     1011100111011101
                          0  X                      1011100111011101
                          0  X                       1011100111011101
                          0  X                        1011100111011101
                          1  X                         1011100111011101
                          0  X                          1011100111011101
                          0  X                           1011100111011101
                    +     1  X                            1011100111011101
        ---------------------------------------------------------------------
             Result:       1011001000111111110100100111011100110101
```

Because the generator coefficient vector **g** is a constant and only has 5 '1' s, the above calculation can be simplified as:

```
                                 0000100011010110111011010000000000000000
                      1  X      11100111011101
                      1  X      1011100111011101
                      1  X            1011100111011101
                      1  X                       1011100111011101
               +      1  X                            1011100111011101
             ---------------------------------------------------------------
        Result:        1011001000111111110100100111011100110101
```

Clearly, the calculation illustrated above is much simpler than the one shown on the previous page. Therefore, it is used in the software implementation for word-wise cyclic shift.

Note: So far the shift direction for syndrome calculation has been assumed to be to the left. However, in a practical situation using DSP processors it is likely that the message has been reversed in previous operations, and therefore in order to adapt the software better for such processors, right cyclic shifting is actually selected to implement the syndrome calculation.

In a sample assembly code for syndrome calculation with word-wise cyclic shift, it only takes 276 instruction cycles in total and about 1.23 cycles per bit to complete the syndrome calculation of the 224 input bits. This represents a saving of instruction cycles over the presently used bit-wise technique.

4.2. Reversed Word-wise Error Trapping

Having used right cyclic shifting for syndrome calculation, left cyclic shifting is used for error trapping, using the circuit of figure 7. Since the whole error trapping circuit is flipped from left to right including the generator coefficient there is no fundamental difference between the circuits of figure 5 and figure 7.

Conventionally, the error trapping is implemented with bit-wise cyclic shift, as described in section 2.2. above, so that the exact location of the error burst can be determined. The error pattern trapped in the most significant 12 bits of the syndrome register is XOR'ed to a position of the received data determined from the number of cycles of the error trapping circuit needed to trap the error.

It is time consuming and difficult for error correction while the data are stored word by word, which is often the case on modern DSP processors. To overcome these limitations, the word-wise cyclic shift is applied to achieve 'word-wise error trapping'. This technique locates the error burst in terms of "which word?" rather than which bit, which makes the error correction much easier. In other words, the error trapping circuit is cycled in a word-wise manner and a pointer indicating the part of the data to be corrected is incremented word-by-word rather than bit-by-bit. The implementation of this 'reversed word-wise error trapping' involves the following 3 stages:

> 1.Reversed word-wise cyclic shift
> 2.Error Detection
> 3.Error correction

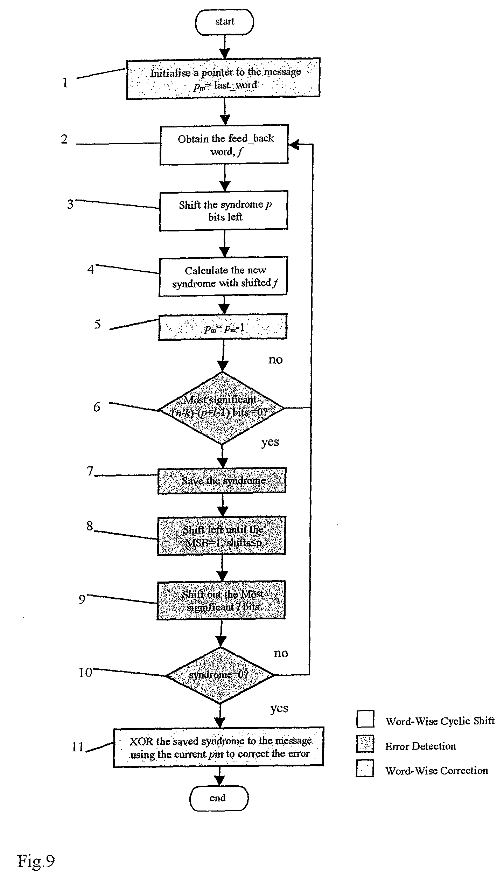

These stages are illustrated by the flow chart of figure 9.

4.2.1. Reversed Word-wise Cyclic Shift

At step 1 of the flow chart of figure 9, a pointer is initialised to the last or least significant word of the received message.

By comparing Figure 2 and Figure 5, it will be apparent that word-wise cyclic shifting can be carried out by a process that is analogous to word-wise syndrome calculation. The specific example of shifting 16 bits at a time can be generalised to shifting any number of bits greater than one, as described below.

Given the shortened fire code (n,k), which has M feed back taps at the positions, $m_0, m_1, m_2, ..... m_M$ of the syndrome register, the reversed word-wise error trapping is completed with the following steps.

> 1. Assuming that the right cyclic shift is applied for syndrome calculation (the opposite to figure 2), the left most word is taken as the feedback word $f$ (step 2).
> 2. Shift the syndrome $p$-bits left, and append 0s to the right most $p$-bits. Here, $p$ is word length (step 3).
> 3. Shift $f$ right by $m_0, m_1, m_2, ..... m_M$ respectively, and XOR them together with the shifted syndrome to obtain the new syndrome (step 4).

$$S_q = S_{q-} <<_P \text{XOR} (f >> m_0) \text{ XOR} (f >> m_1) \text{ XOR} ...... (f >> m_M)$$

The shifts can be in either direction provided that the syndrome is shifted in the opposite direction to $f$.

To apply the word-wise error trapping to a fire code, the following conditions have to be met.

If the error trapping is performed every $p$ bits, then in order to ensure that the whole error pattern of up to $l$ bits is not shifted and hence missed, the following condition has to be satisfied:

$$p + l - 1 \leq n - k$$

where *l* is the burst-error-correcting capability.

In a sample assembly code implementing the above process, for each reversed word-wise cyclic shift, it takes only 14 instruction cycles. This operation continues until a correctable error pattern is trapped or the whole received sequence is searched.

After each new syndrome is calculated, the pointer is decremented as indicated in step 5 in figure 9.

4.2.2. Error Detection

This stage verifies whether or not a correctable error has been trapped in the syndrome register.

If the most significant $(n-k)$-$(p+l$-1) bits of the new syndrome are zeros (decision stage 6), a correctable error pattern may have been trapped. This, if "yes" at step 6 these zeros are shifted out the error detection continues, Step 6 represents a primary test for a correctable error, to be explained in more detail below. If "no" the previous steps are repeated to obtain the next syndrome. Save the syndrome (step 7). Shift the saved syndrome left bit by bit for at most *p* times until a '1' is detected at the MSB of the syndrome (step 8). If there is a correctable error burst, it should now be contained in the most significant *l* bits of the syndrome register. Shift out the most significant *l* bits of the syndrome from the left (step 9). If only 0 remains in the syndrome register (Decision 10), then a correctable error is detected, otherwise return to the step of error trapping. If a correctable error is detected, the saved syndrome is XOR'ed to the received message, the relevant bits to be corrected being determined by the pointer (step 11).

Refer to fig. 5, the error pattern is trapped at the most significant 12 bits. For reversed cyclic shifts, these are actually the last 12 bits to be shifted out of the register. The means that even for an extra word-wise shift after the error is trapped at the 12 most significant bits, only zeros will be shifted and hence , the error pattern will not be changed or shifted out the register, and is still visible in the syndrome register. This validates the use of word-wise cyclic shift for error trapping.

The worst case of 'over shifting' with word-wise cyclic shift is illustrated Figure 8.

Where the error pattern is over shifted by 15 bits after a certain word-wise cyclic shift, 13 zeros still remain in the front of the syndrome register. This fact leads to a conclusion: ' if a correctable error pattern is found during a reversed word-wise cyclic shift, after sufficient shifts there will be at least 13 zeros located in the front of the syndrome register'. This fact is used as a condition for the primary test that is performed after every reversed word-wise cyclic shift for a correctable error pattern. If the condition is satisfied, further study will be carried out on the contents of syndrome register, otherwise the word-wise cyclic shift carries on. Step 6 represents a generalisation of this specific example.:

Error correction will take place if a correctable error pattern is trapped in the syndrome register.

4.2.3. Error correction

If a correctable error burst is detected, this step will take place to correct the error.

A pointer is initialised to the last word's address of the received message at the beginning of error trapping. Every time a new syndrome is obtained by error trapping the pointer is decreased by 1, and point to the word in front. When a correctable error is detected, the pointer points to the first word containing the error. By XOR'ing the last *u* words of the saved syndrome to the *u* words in the message starting at the current pointer's address. The value of *u* is determined with the following formula.

$$u = 2+(l/p)$$

Where, *p* is the word length.

In the specific case where n-k = 40, 1 = 12 and p = 16, with word-wise cyclic shift, the error pattern is trapped in the syndrome register at a position that matches the location of the error burst in the corresponding two words of the received sequence stored in the 16-bit data memory. This is illustrated in Figure 8. Only two of the many possible memory locations are illustrated.

Therefore, by simply XOR'ing the lower 32 bits of the syndrome register to the corresponding two words in the data memory, the error burst can be corrected.

5. Processing requirement.

The first two steps ofthe decoding, Initialisation' and 'Syndrome Calculation' are performed for every received sequence r(X), costing a fixed number of instruction cycles. However, the steps of, 'Error Trapping and Correction' are only carried out after a non-zero syndrome being obtained, and the number of instruction cycles required varies under different circumstances. Therefore, the worst situation has to be considered for the evaluation of the maximum processing requirement.

The worst situation is assumed that after the reversed word-wise cyclic shifts, the syndromes having the structures shown in fig. 10 are obtained. One should notice that this situation is only assumed for the purpose of study. It will never happen in reality.

For the first 13 reversed word-wise cyclic shifts, the syndrome contains an uncorrectable error pattern having the length of 13 bits, and being located at the least significant 13 bits.

After the last reversed word-wise cyclic shift, a correctable error pattern is contained in the syndrome, which is located at the least significant 12 bits.

6. Conclusion

With the new techniques described above, the processing speed of the Fire decoder has been greatly improved without invoking any hardware modification to an existing DSP chip.

In spite of the much higher processing speed achieved by word-wise cyclic shift for error trapping, this technique has also brought another important benefit, which allows the error burst to be corrected also in the word-wise manner.

With word-wise error trapping, the error pattern is trapped in the syndrome register at a position that matches exactly with the location of the error burst in the corresponding two words of the received sequence stored in the 16-bit data memory. Therefore, by simply XOR'ing the lower 32 bits of the syndrome register to the corresponding two words in the data memory, the error burst can be corrected. This makes the implementation of the error burst correction much easier on the 16-bit DSP processors, where bit wise operations are normally difficult and time consuming.

**Claims**

1.    A method of locating an error in a cyclic codeword of length $n$ having $k$ message bits and ($n$-$k$) parity bits obtained from a generator polynomial of general formula:

$$g(D) = D^{m_0} + D^{m_1} + D^{m_2} + D^{m_4} + \ ..... \ + D^{m_m}$$

the method comprising computing a syndrome $s$ of length ($n$-$k$) of said cyclic codeword , and performing an error trapping operation on said syndrome to locate a correctable error pattern of length $l$ bits in which the syndrome is shifted by a plurality $p$ of bits to produce a new syndrome, and said shifting is repeated if necessary until a correctable error pattern is identified.

2.    A method as claimed in claim 1 wherein each step of shifting the syndrome to produce a new syndrome comprises:

shifting the syndrome in one direction by a plurality, $p$, of bits to
produce a feedback word $f$ of length $p$,
filling with zeros bit positions of said syndrome vacated as a result of said shifting;
shifting the feedback word in the opposite direction by $m_0$, $m_1$, $m_2$ .....$m_m$ respectively and modulo 2 adding the shifted feedback words to the shifted syndrome to obtain a new syndrome.

3.    A method as claimed in claim 1 or 2 in which the error trapping operation is repeated until all of the bits of the syndrome are zeros except for a group of $l$ adjacent bits, signifying the presence of burst error of length $l$ in the code word.

4.    A method as claimed in claim 1, 2 or 3, including the steps of:
repeatedly shifting the syndrome by a plurality $p$ of bits to produce a new syndrome until the next ($n$-$k$) - ($p + l$ -1) bits to be shifted out from one end of the syndrome are all zero.

5.    A method as claimed in claim 4, including carrying out a preliminary test for the presence of a correctable error pattern comprising the steps of saving the syndrome whose end *(n-k) - (p + l -1)* bits are zero, shifting the bits of said saved syndrome one at a time for up to $p$ bits until the next bit to be shifted out is 1, shifting at the next $l$ bits representing a possible error pattern and ascertaining whether the remaining bits are zero, in which case a correctable error patter has been located in said $l$ adjacent bits.

6. A method as claimed in any preceding claim in which the part of the syndrome containing a correctable error pattern is XOR' ed to the message at bit positions corresponding to the number of shifts of the syndrome in order to correct the message.

7. A method as claimed in claim 6, in which the bits of the message are stored in respective memories each containing $p$ bits and the bits of the syndrome are XOR'ed to the bits of the message $p$ bits at a time.

8. A method as claimed in claim 7, in which a pointer moves from one memory location to an adjacent memory location for each $p$ bit shift of the syndrome to indicate the location of data to be corrected.

9. A method as claimed in any preceding claim in which said one direction of shifting is the opposite direction to the direction of shifting used during computation of said syndrome.

10. A method as claimed in any preceding claim in which the cyclic code is a Fire code.

11. A method as claimed in any preceding claim in which $p \geq 8$.

12. A method as claimed in any preceding claim in which $p=16$.

13. A method as claimed in any preceding claim in which the syndrome is calculated by shifting the message bit into a syndrome calculation circuit $p$ bits at a time.

Fig.1        encoder

Message bits (184)

Fig.2.        syndrome circuit left cyclic shift

Input bits (224)

Test for all zeros

Fig.3.        error trapping circuit

Full code word 3,014,656

3,014,432 zeros        184 message bits        40 parity bits

Shortened fire code

Fig. 4

Test for all zeros

Fig. 5

⊡ : Error pattern

40-bit syndrome register ← shifting direction

Fig 6.

Test for all zeros

Fig 7.

⊡ : Error pattern
P : Pointer to input buffer

Fig 8.

start

1 — Initialise a pointer to the message
$p_m$ = last_word

2 — Obtain the feed_back word, $f$

3 — Shift the syndrome $p$ bits left

4 — Calculate the new syndrome with shifted $f$

5 — $p_m = p_m - 1$

6 — Most significant $(n-k)-(p+l-1)$ bits = 0?   no   yes

7 — Save the syndrome

8 — Shift left until the MSB=1, shifts=p

9 — Shift out the Most significant $l$ bits

10 — syndrome=0?   no   yes

11 — XOR the saved syndrome to the message using the current $pm$ to correct the error

end

☐ Word-Wise Cyclic Shift

▨ Error Detection

☐ Word-Wise Correction

Fig.9